Europäisches Patentamt

European Patent Office

Office européen des brevets

(11) Numéro de publication: **0 267 091 B1**

# FASCICULE DE BREVET EUROPEEN

(45) Date de publication de fascicule du brevet:
**29.05.91**

(51) Int. Cl.⁵: **G11C 17/00**, G11C 16/02

(21) Numéro de dépôt: **87402315.3**

(22) Date de dépôt: **16.10.87**

(54) **Mémoire non-volatile programmable électriquement.**

(30) Priorité: **20.10.86 FR 8614523**

(43) Date de publication de la demande:
**11.05.88 Bulletin 88/19**

(45) Mention de la délivrance du brevet:
**29.05.91 Bulletin 91/22**

(84) Etats contractants désignés:
**DE ES FR GB IT**

(56) Documents cités:
**EP-A- 0 050 005**
**FR-A- 2 430 065**

(73) Titulaire: **SGS-THOMSON MICROELECTRO-NICS S.A.**
**7, Avenue Galliéni**
**F-94250 Gentilly(FR)**

(72) Inventeur: **Fruhauf, Serge**
**THOMSON-CSF SCPI 19, avenue de Messine**
**F-75008 Paris(FR)**
Inventeur: **Marquot, Alexis**
**THOMSON-CSF SCPI 19, avenue de Messine**
**F-75008 Paris(FR)**

(74) Mandataire: **Schmit, Christian Norbert Marie et al**
**Cabinet Ballot-Schmit 7, rue Le Sueur**
**F-75116 Paris(FR)**

## Description

La présente invention concerne les mémoires non-volatiles programmables électriquement. Elles concernent plus particulièrement les mémoires non-volatiles programmables électriquement réalisant un appel de courant sur la tension de programmation telles que, par exemple, les mémoires EPROM ou EEPROM.

En général, dans les mémoires du type EPROM ou EEPROM, chaque élément de stockage d'information ou cellule-mémoire est constitué par un transistor MOS à grille flottante. Un transistor MOS à grille flottante peut avoir deux états. Pour un transistor MOS à canal N, dans un premier état aucune charge n'est piégée sur la grille flottante. Un canal de conduction peut exister entre source et drain. Le transistor conduit alors et se comporte comme un interrupteur fermé. Dans un deuxième état, les électrons ont été piégés sur la grille flottante. Ils empêchent la création d'un canal de conduction dans le substrat entre source et drain. Dans ce cas, le transistor est bloqué et se comporte comme un interrupteur ouvert. Pour programmer un transistor MOS à grille flottante tel que décrit ci-dessus, des tensions plus élevées que la tension de fonctionnement normale doivent être appliquées sur la grille de commande et l'une des électrodes de sorte que la grille flottante puisse absorber et garder une charge d'électrons. D'autre part, pour lire une mémoire ainsi programmée, une tension de lecture spécifique doit être appliquée sur la grille de commande, cette tension de lecture permettant de détecter l'état passant ou bloqué du transistor.

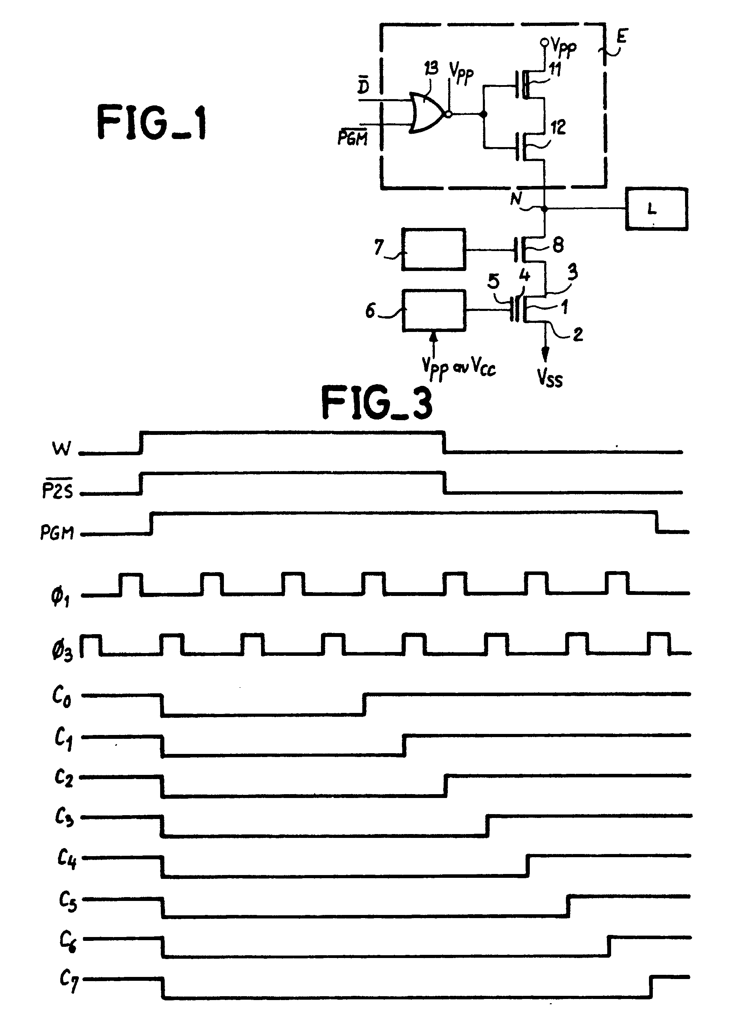

Pour pouvoir appliquer les tensions nécessaires à la programmation ou à la lecture d'une cellule-mémoire constituée par un transistor MOS à grille flottante, celui-ci est en général connecté de la manière représentée sur la figure 1. Ainsi, une des électrodes principales du transistor MOS 1 à grille flottante, à savoir la source 2 dans le mode de réalisation représenté, est reliée à la tension $V_{SS}$ représentant la masse tandis que l'autre électrode ou drain 3 est reliée par l'intermédiaire d'une ligne de bits non représentée et d'un transistor MOS formant interrupteur 8 à un décodeur d'adresses de colonnes 7. La grille de commande 5 du transistor MOS 1 est reliée par l'intermédiaire d'une autre connexion dite ligne de mots, non représentée, à un décodeur d'adresses de lignes 6. Les lignes de bits et lignes de mots sont arrangées en lignes et en colonnes pour déterminer une matrice incluant la cellule-mémoire constituée par le transistor MOS 1 à grille flottante de manière connue de l'homme de l'art. En fait, le décodeur d'adresses de colonnes 7 est relié à la grille du transistor 8 dont la source est reliée au drain 3 du transistor 1 tandis que son drain est connecté respectivement au circuit d'écriture E et à un circuit de lecture symbolisé par le bloc L.

Le circuit d'écriture E est réalisé de manière que la tension de programmation, à savoir la tension $V_{PP}$ soit appliquée au niveau du noeud N lorsque la cellule-mémoire 1 doit être programmée, c'est-à-dire lorsqu'elle doit enregistrer une donnée correspondant à "1". Au contraire si la cellule-mémoire 1 ne doit pas être programmée, la tension au noeud N pendant l'écriture doit rester à "0". Comme représentée sur la figure 1, le circuit d'écriture est en général constitué par une ligne de charge comprenant un transistor MOS 11 déplété dont l'une des électrodes est reliée à la tension $V_{PP}$ constituant la tension de programmation et dont l'autre électrode est reliée à l'une des électrodes du transistor MOS 12 enrichi. L'autre électrode du transistor 12 est connectée au noeud N. Les deux grilles des transistors 11 et 12 sont reliées en commun à un circuit de commande de programmation constitué par une porte NI 13 alimentée à la tension $V_{PP}$. Cette porte NI 13 reçoit respectivement sur ses deux entrées un signal $\overline{D}$ correspondant à la donnée à programmer inversée et un signal $\overline{PGM}$ correspondant au signal de commande de programmation inversé. En conséquence, avec le circuit ci-dessus, lorsqu'on programme le transistor MOS 1 à grille flottante au niveau logique "1", on observe une variation de courant sur l'alimentation de la tension de programmation $V_{PP}$.

Dans les applications dans lesquelles sont utilisées les mémoires non-volatiles programmables électriquement du type de celles décrites ci-dessus, il est rare de programmer les cellules-mémoire une-à-une. En fait, elles sont le plus souvent programmées sous forme d'un mot, c'est-à-dire que huit cellules-mémoire par exemple sont programmées en parallèle pour un mot de 8 positions binaires ou bits. De ce fait, on observe sur l'alimentation de la tension de programmation $V_{PP}$ un appel de courant qui correspond à huit cellules-mémoire. Or, l'appel de courant sur l'alimentation de la tension de programmation $V_{PP}$ pour une cellule-mémoire est en général de l'ordre de 1 à 2 milliampères. De ce fait, lorsque les huit cellules-mémoire sont programmées à "1" par exemple, l'appel de courant sur l'alimentation de la tension de programmation $V_{PP}$ peut monter jusqu'à une valeur comprise entre 8 milliampères et 16 milliampères. Or, lorsque l'on passe du mode programmation ou écriture au mode lecture, on vient désactiver les circuits d'écriture sur les huit cellules-mémoire en même temps. Ceci provoque une chute brutale du consommation puisqu'alors le courant de programmation $I_{PP}$ passe de 16 milliampères à zéro milliampère. Cette variation du courant de programmation $I_{PP}$ peut alors provoquer un pic de tension sur l'alimentation de la tension de programmation $V_{PP}$. Ce pic peut atteindre une valeur $\Delta V_{PP}$ de 7 volts. Or, ce pic est très dangereux pour l'ensemble des circuits. En effet, les transistors inclus dans les circuits sont prévus pour tenir une tension maximale définie par la technologie utilisée qui est de 25 volts pour une technologie en 4 micromètres et 16 volts pour une technologie en 2 micromètres. Les variations sur la tension de programmation $V_{PP}$, qui est en fait la tension la plus élevée du circuit, risquent donc de détruire le circuit si on dépasse la garde prévue et en conséquence de le rendre inutilisable.

La présente invention a donc pour but de remédier à ces inconvénients.

En conséquence, la présente invention a pour objet une mémoire non-volatile programmable électriquement comportant une matrice de cellules-mémoire accessible par des lignes et des colonnes, des circuits d'écriture et de lecture appliquant sur les lignes et les colonnes des potentiels représentatifs de la donnée programmée ou représentatifs de commande de lecture et des moyens gérant l'interconnexion des circuits d'écriture et de lecture avec les cellules-mémoire, dans laquelle N cellules-mémoire sont programmées simultanément avec N supérieur à 1, chaque cellule-mémoire réalisant un appel de courant lors de sa programmation à "1", caractérisée en ce qu'elle comporte des premiers moyens pour désactiver un par un les circuits d'écriture correspondant aux N cellules-mémoire lors du passage d'un mode programmation dans un mode lecture et des deuxièmes moyens pour court-circuiter les premiers moyens lors du passage en mode programmation.

Selon un mode de réalisation préférentiel, les premiers moyens sont constitués par un registre à décalage à une entrée recevant le signal de commande de lecture-écriture et à N-1 sorties, l'entrée et les N-1 sorties étant envoyées respectivement sur les N circuits d'écriture, le registre à décalage étant commandé par des signaux horloge commutant les sorties une par une. D'autre part, les deuxièmes moyens pour court-circuiter les premiers moyens lors du passage en mode programmation sont constitués par un circuit en logique combinatoire activée par le signal de commande de lecture-écriture et par le signal de commande de programmation généré en fin de lecture, le circuit en logique combinatoire étant connecté entre le registre à décalage et les circuits d'écriture. Le signal de commande de programmation est généré à partir du signal de commande de lecture-écriture par l'intermédiaire d'un circuit séparateur de signaux activés par le signal de commande du $N^{ième}$ circuit d'écriture. De plus, Le registre à décalage reçoit un signal de remise à niveau lors de la mise sous tension.

D'autres caractéristiques et avantages de la présente invention apparaîtront à la lecture de la description d'un mode de réalisation faite ci-après avec référence aux dessins ci-annexés dans lesquels:

- la figure 1, déjà décrite, représente schématiquement une cellule-mémoire EPROM connectée à des circuits d'écriture et de lecture susceptibles de recevoir les circuits de la présente invention;
- la figure 2 représente un mode de réalisation des circuits conformes à la présente invention, destinés à être connectés entre le registre d'entrée et les circuits d'écriture;
- la figure 3 représente un diagramme des temps des principaux signaux commandant ou sortant des circuits conforme à la présente invention,
- la figure 4 représente les courbes $I_{PP}$ et $V_{PP}$ en fonction du temps dans le case d'une mémoire de l'art antérieur et d'une mémoire munie de circuits conformes à la présente invention, et
- la figure 5 représente un autre mode de réalisation d'un registre à décalage utilisable dans la présente invention.

Pour simplifier la description, dans les dessins les mêmes éléments portent les mêmes références. D'autre part, la description a été faite en se référant à des circuits MOS réalisés en technologie N MOS ainsi qu'à une mémoire de type EPROM dont les cellules-mémoire sont constituées par des transistors MOS à grille flottante de type SAMOS (pour Stacked Gate Avalanche Injection MOS). Toutefois, il est évident pour l'homme de l'art que la présente invention peut s'adapter à d'autres technologie ou à d'autres types de mémoires.

Conformément à la présente invention, on prévoit entre le registre d'entrée R1 permettant d'obtenir le signal de commande de programmation PGM et le signal de commande d'écriture et de lecture $\overline{P2S}$ et les N circuits d'écriture utilisés pour réaliser la programmation en parallèle de N cellules-mémoire, des moyens pour désactiver un par un les circuits de lecture correspondant aux N cellules-mémoire lors du passage d'un mode programmation dans un mode lecture et des deuxièmes moyens pour court-circuiter les premiers moyens lors du passage en mode programmation.

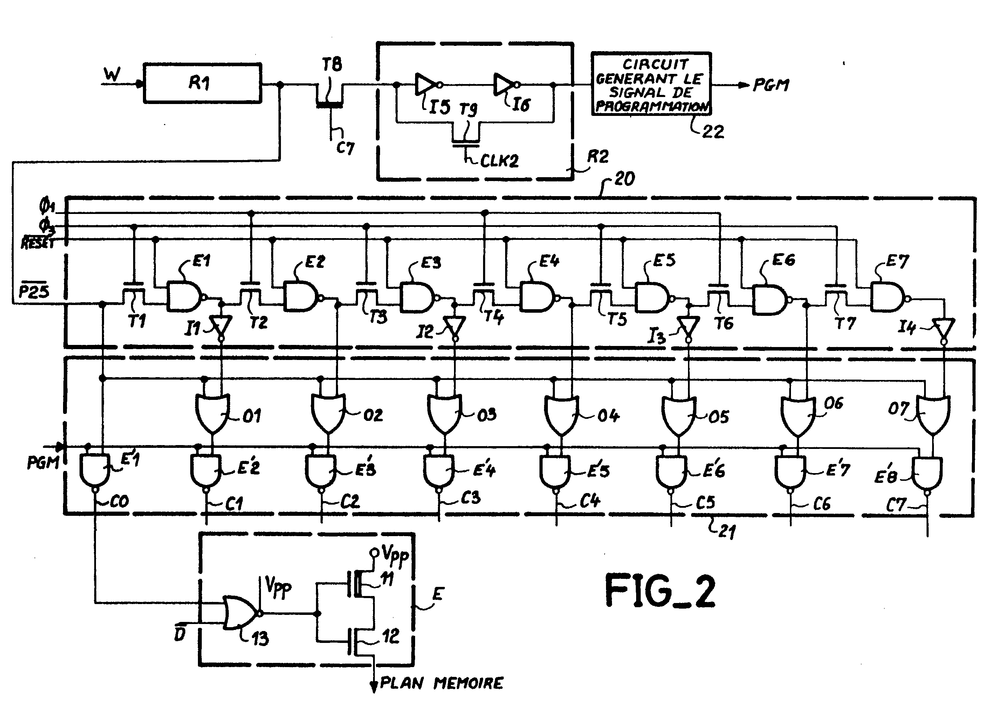

Comme représenté sur la figure 2, qui concerne la programmation de huit cellules-mémoire en parallèle, les premiers moyens pour désactiver un par un les circuits d'écriture correspondant aux N cellules-mémoire lors du passage d'un mode programmation dans un mode lecture sont constitués essentiellement par un registre à décalage 20 et les deuxièmes moyens pour court-circuiter les premiers moyens lors du passage en mode programmation sont constitués essentiellement par un circuit en logique combinatoire 21 associé à un séparateur de signaux R2 mis en oeuvre par un interrupteur commandé par la N$^{ième}$ sortie du circuit 21.

De manière plus spécifique, le registre à décalage 20 est constitué de N-1 portes NON-ET, à savoir 7 portes NON-ET E1 à E7 dans le mode de réalisation représenté, connectées en série par l'intermédiaire de 7 transistor MOS T1 à T7 montés en interrupteur. Ainsi, une des électrodes principales des transistors MOS T1 à T7 est connectée sur une des entrées des portes NON-ET E1 à E7 tandis que son autre électrode principale est connectée à la sortie de la porte NON-ET précédente, le premier transistor MOS T1 recevant sur son autre électrode le signal de commande de lecture-écriture $\overline{P2S}$ issu du registre R1. D'autre part, les grilles des différents transistors T1 à T7 sont connectés à des signaux horloge Ø₁ ou Ø₃ commutant les sorties une par une. En fait, les signaux Ø₁ et Ø₃ sont des signaux de séquencement obtenus à partir du signal horloge de la mémoire qui présentent la particularité d'avoir des impulsions décalées les unes par rapport aux autres de manière à ne jamais être au niveau logique "1" en même temps. Ainsi, comme représenté sur la figure 2, les grilles des transistors MOS interrupteurs impairs, à savoir des transistors T1, T3, T5 et T7, sont commandées par le signal Ø₃ tandis que les grilles des transistors MOS interrupteurs pairs T2,T4 et T6 sont commandées par le signal Ø₁. D'autre part, l'autre entrée des portes NON-ET E1 à E7 reçoit un signal de remise à niveau, plus particulièrement un signal de remise à "1" référencé $\overline{Reset}$ sur la figure. Les sorties des portes NON-ET impaires E1,E3,E5 et E7 sont connectées à des inverseurs I1,I2,I3 et I4. Les sorties du registre à décalage 20 sont donc réalisées par les sorties des inverseurs I1,I2,I3,I4 et les sorties des portes NON-ET E2,E4,E6, dans le mode de réalisation représenté.

Conformément à la présente invention, ces sorties sont envoyées en entrée du circuit en logique combinatoire 21 utilisé pour court-circuiter le registre à décalage lors du passage en mode programmation. Ce circuit 21 est constitué essentiellement de portes OU O1 à O7 et de portes NON-ET E'1 à E'8 commandées respectivement par les sorties du registre à décalage 20, le signal de commande de lecture-écriture $\overline{P2S}$ et le signal de commande de programmation PGM. De manière plus spécifique, chaque sortie du registre à décalage 20 est envoyée sur une entrée d'une porte OU O1 à O7 dont l'autre entrée reçoit le signal de commande de lecture-écriture $\overline{P2S}$. Les sorties des portes OU O1 à O7 sont envoyées respectivement sur une des entrées des portes NON-ET E'2 à E'8 respectives dont l'autre entrée reçoit le signal de commande de programmation PGM. D'autre part, la porte NON-ET E'1 reçoit sur une de ses entrées le signal de commande de programmation $\overline{P2S}$ et sur son autre entrée le signal PGM. Les sorties des portes NON-ET E'1 à E'8 donnent les huit signaux de commande de "bits" C0 à C7 qui commandent chacun un des circuits d'écriture E en remplacement du signal $\overline{PGM}$ dans le mode de réalisation de la figure 1. Ainsi, comme représenté sur la figure 2, le signal C0 est envoyé sur une entrée de la porte NI 13 alimentée par $V_{PP}$ et qui reçoit sur son autre entrée la donnée à programmer sous forme inversée à savoir le signal $\overline{D}$. La sortie de cette porte NI 13 est connectée aux deux grilles des transistors MOS 11 et 12 formant la ligne de charge d'une cellule-mémoire non représentée. Pour simplifier la description, on a représenté qu'un seul circuit d'écriture E relié à la commande C0. Toutefois, il est évident pour l'homme de l'art que les commandes C1 à C7 sont chacune reliées à un circuit d'écriture semblable à celui représenté sur la figure 2.

D'autre part, comme représenté sur la figure 2, le signal $\overline{P2S}$ est obtenu en sortie du registre R1 bien connu de l'homme de l'art qui reçoit en entrée un ordre de lecture ou d'écriture représenté par le signal W. Le registre R1 est en général, constitué par un registre dynamique. De plus, le signal issue du registre R1 est envoyé vers un circuit 22 générant le signal de programmation PGM par l'intermédiaire d'un séparateur de signaux R2 mis en oeuvre par un interrupteur constitué par le transistor MOS T8 dont la grille est reliée au signal de commande de bits C7. Le séparateur de signaux R2 est constitué lui aussi par un registre dynamique de type connu, à savoir par deux inverseurs 15 et 16 normalement précédés par des capacités de stockage non représentées permettant de stocker l'information en entrée. La sortie de l'inverseur 16 est rebouclée sur l'entrée de l'inverseur 15 par l'intermédiaire d'un transistor MOS T9 dont la grille est connectée à l'une des horloges de la mémoire référencée CLK2. La sortie du circuit R2 est envoyée sur le circuit 22 générant le signal de programmation bien connu de l'homme de l'art et qui ne sera pas redécrit ici. En sortie du circuit 22 on obtient le signal de commande de programmation PGM qui permet notamment de commuter sur la grille 5 du transistor MOS à grille flottante 1 constituant une cellule-mémoire soit la tension de programmation $V_{PP}$ soit la tension d'alimentation $V_{CC}$ suivant que l'ordre en entrée du registre R1 est un ordre d'écriture ou un ordre de lecture.

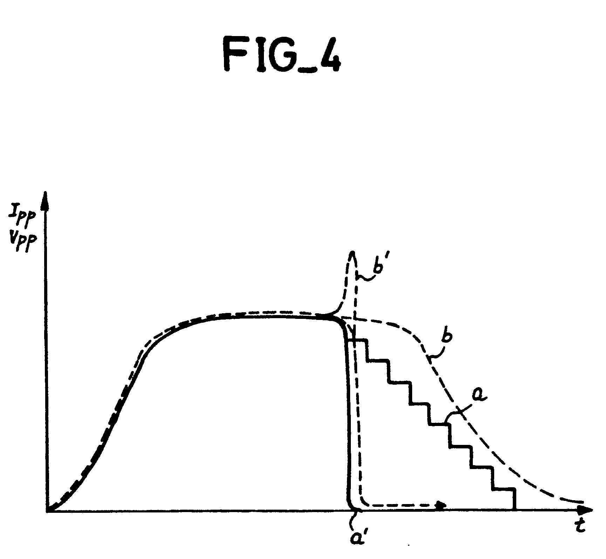

On décrira maintenant avec référence à la figure 3 le fonctionnement du circuit ci-dessus. Ainsi lorsque l'ordre d'écriture W passe au niveau "1" on obtient en sortie du registre R1 un signal de commande de lecture-écriture $\overline{P2S}$ qui passe lui aussi au niveau "1". Comme le signal de commande de bits C7 appliqué sur la grille du transistor T8 se trouve être au niveau logique "1", le transistor T8 formant interrupteur est passant. De ce fait le séparateur de signaux R2 est en fonctionnement. Il commande donc le circuit 22 générant le signal de programmation et l'on obtient en sortie de ce circuit un signal PGM qui s'établit au niveau "1" avec un certain retard. Lorsque le signal PGM passe un niveau "1", on établit la tension de programmation $V_{PP}$ sur l'ensemble de la mémoire. Puisque les signaux de commande de programmation PGM et de commande de lecture-écriture $\overline{P2S}$ sont tous deux au niveau "1", les sorties C0 à C7 des portes NON-ET E'1 à E'8 passent au niveau logique "0", niveau pour lequel elles sont actives pour commander les différents circuits d'écriture E comme expliqué ci-dessus avec référence à la figure 1. En effet, le signal de commande de lecture-écriture $\overline{P2S}$ est appliqué sur les portes NON-ET E1 à E8 directement pour la porte NON-ET E'1 ou par l'intermédiaire de portes OU O1 à O7 dont la sortie appliquée en entrée des portes NON-ET E'2 à E'8 se trouve au niveau logique "1" dès qu'une des entrées est au niveau logique "1". Dans ce cas, le fonctionnement du registre à décalage 20 est inactif sur les sorties C0 à C7. Lorsque la commande C7 passe au niveau logique "0", le transistor T8 se bloque séparant le registre R1 du registre R2. Toutefois, le registre R2 effectue un rafraichissement de la donnée en entrée ce qui permet de maintenir le signal de programmation PGM au niveau logique "1".

Lorsque l'ordre d'écriture W passe au niveau logique "0", c'est-à-dire lors du passage d'un mode programmation dans un mode lecture, le signal en sortie du registre R1, à savoir le signal de commande lecture-écriture $\overline{P2S}$, passe au niveau logique "0". A ce moment la sortie C0 de la porte NON-ET E'1 passe au niveau logique "1" ce qui bloque le circuit d'écriture E et entraîne un appel de courant sur la tension d'alimentation $V_{PP}$ correspondant à un circuit d'écriture. D'autre part, une des entrées des portes OU O1 à O7 se trouve donc au niveau zéro tandis que les autres entrées constituées par les entrées du registre 20 sont encore au niveau logique 1. En conséquence, les sorties des portes OU O1 à O7 se trouvent au niveau logique "1" et les sorties C1 à C7 des portes NON-ET E'2 à E'8 restent au niveau logique "0" n'entraînant pas le blocage des circuits d'écriture correspondants Lorsque $\emptyset_3$ passe au niveau logique "1" c'est-à-dire lorsqu'une impulsion de $\emptyset_3$ est présente sur la grille du transistor T1, ce dernier devient passant et met une des entrées de la porte NON-ET E1 au niveau logique "0". L'autre entrée de la porte NON-ET E1 se trouvent au niveau logique "1", la sortie de cette porte NON-ET E1 passe au niveau logique "1" ce qui entraîne en sortie de l'inverseur I1 un niveau logique "0". La porte OU O1 recevant en entrée deux niveaux logiques "0", sa sortie passe au niveau logique "0" et la sortie C1 de la porte NON-ET E'2 passe au niveau logique "1" entraînant le blocage du circuit d'écriture correspondant. De même, lorsque $\emptyset_1$ passe au niveau logique "1", le transistor T2 devient passant. L'entrée correspondante de la porte NON-ET E2 passe au niveau logique "1" et la sortie de cette porte NON-ET E2 passe au niveau logique "0". Ainsi, les deux entrées de la porte OU O2 étant au niveau logique "0", sa sortie passe au niveau logique "1" entraînant le passage au niveau logique "1" de la sortie C2 de la porte NON-ET E'3. Lorsque $\emptyset_3$ passe au niveau logique "1", le transistor T3 devient passant entraînant le passage de l'information en sortie de la porte E2 sur l'entrée de la porte E3. Ceci provoque le passage de la commande C3 au niveau logique "1" de manière identique au passage de la commande C1. Lorsque $\emptyset_1$ repasse au niveau logique "1", le transistor T4 se ferme et ainsi de suite pour les transistors T5 à T7 qui fonctionnent de manière identique aux transistors T1 à T4.

Avec le circuit décrit ci-dessus on obtient une diminution pas à pas du courant de programmation $I_{PP}$ en fonction du temps t comme représenté par la courbe a sur la figure 4 à la place d'un passage instantané à zéro tel que représenté par la courbe a'. En conséquence, la tension $V_{PP}$ décroît progressivement comme représenté par la courbe b de la figure 4 au lieu de montrer le pic de courant représenté sur la courbe b'. Ceci évite l'endommagement des circuits de la mémoire.

Il est évident pour l'homme de l'art que d'autres types de registre à décalage 20 et de circuit en logique combinatoire 21 peuvent être utilisés dans la présente invention.

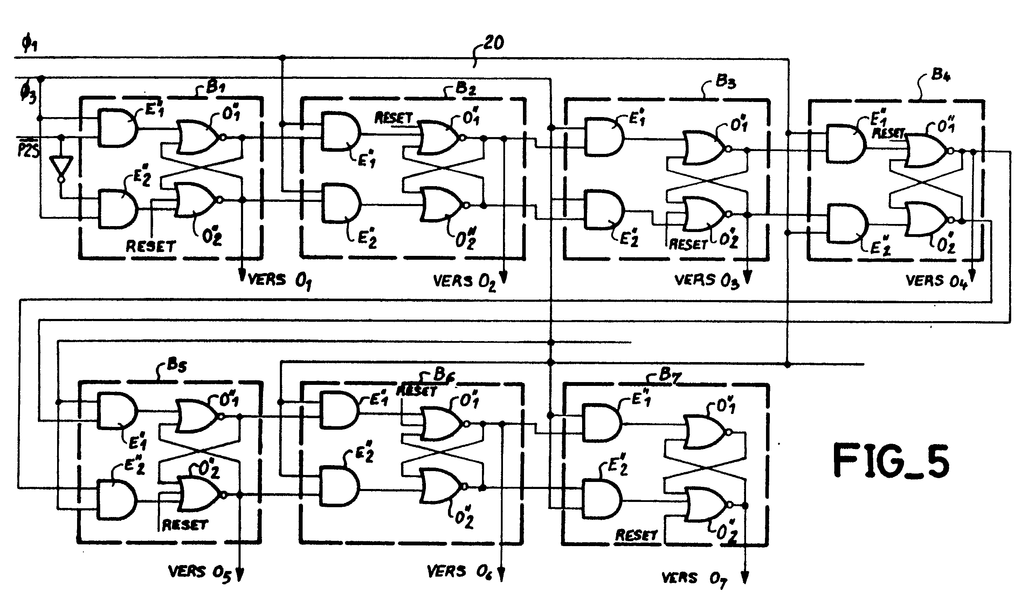

Ainsi, comme représenté sur la figure 5, le registre à décalage 20 peut être réalisé à l'aide de bascules maître-esclave B1 à B7.

De manière plus spécifique, la bascule B1 comporte deux portes ET E'1 et E'2 connectées respectivement à deux portes NI O"1 et O"2. Ainsi, la porte ET E"1 reçoit en entrée respectivement le signal $\overline{P2S}$ et le signal $\emptyset 3$ tandis que la porte ET E"2 reçoit le signal $\overline{P2S}$ inversé par l'inverseur I10 et le signal $\emptyset 3$. Les sorties des portes ET E"1 et E"2 sont envoyées respectivement sur une des entrées des portes NI O"1 et O"2. L'autre entrée de la porte NI O"1 est connectée à la sortie de la porte NI O"2 tandis que l'autre entrée de la porte NI O"2 est connectée à la sortie de la porte NI O"1. De plus, la porte NI O"2 reçoit un signal de remise à zéro Reset. Les sorties des portes NI O"1 et O"2 sont connectées aux entrées de la bascule B2, à savoir respectivement sur une des entrées des portes ET E"1 et E"2 de cette bascule et la sortie de la porte NI O"2 est envoyée une des entrées de la porte OU O1 du circuit en logique combinatoire 21. La structure de la bascule B2 est identique à celle de la bascule B1. Toutefois, les autres entrées des portes ET E"1 et E"2 reçoivent le signal-horloge ∅ I. D'autre part, le signal de remise à zéro Reset est envoyé sur la porte NI O"1 et la sortie de cette porte NI O"1 est connectée à une des entrées de la porte OU O2 du circuit 21. D'autre part, les bascules B3, B5 et B7 reçoivent les mêmes signaux que la bascule B1 tandis que les bascules B4 et B6 reçoivent les mêmes signaux que la bascule B2.

En ce qui concerne le mode de fonctionnement de ce registre à décalage, il est identique à celui décrit pour le registre à décalage 20 de la figure 2.

**Revendications**

1. Mémoire non-volatile programmable électriquement comportant une matrice de cellules-mémoire (1) accessibles par des lignes et des colonnes, des circuits d'écriture (E) et de lecture (L) appliquant sur les lignes et les colonnes des potentiels représentatifs de la donnée à programmer ou représentatifs de commande de lecture et des moyens (6,7) gérant l'interconnexion des circuits d'écriture et de lecture avec les cellules-mémoire, dans laquelle N cellules-mémoire sont programmées simultanément avec N supérieur à 1, chaque cellule-mémoire réalisant un appel de courant lors de sa programmation à "1", caractérisée en ce qu'elle comporte des premiers moyens (20) pour désactiver un par un les circuits d'écriture correspondant aux N cellules-mémoire lors du passager d'un mode de programmation dans un mode lecture et des deuxièmes moyens (21, R2) pour court-circuiter les premiers moyens lors du passage en mode programmation.

2. Mémoire non-volatile programmable électriquement selon la revendication 1, caractérisée en ce que les premiers moyens sont constitués par un registre à décalage à une entrée recevant le signal de commande de lecture-écriture ($\overline{P2S}$) et à N-1 sorties, l'entrée et les N-1 sorties étant connectées respectivement aux N circuits d'écriture (E), le registre à décalage étant commandé par des signaux-horloge ($\varnothing 1$, $\varnothing 3$) commutant les sorties une par une.

3. Mémoire non-volatile programmable électriquement selon la revendication 2, caractérisé en ce que le registre à décalage reçoit un signal de remise à niveau ($\overline{RESET}$, RESET) lors de la mise sous tension.

4. Mémoire non-volatile programmable électriquement selon l'une quelconque des revendications 2 et 3, caractérisée en ce que le registre à décalage est constitué par N-1 portes NON-ET connectées en série par l'intermédiaire de transistors MOS (T1 a T7) formant interrupteurs, les transistors MOS de rang pair (T2, T4, T6) étant commandés par un premier signal-horloge ($\varnothing 1$) et les transistors MOS de rang impairs (T1, T3, T5, T7) étant commandés par un deuxième signal horloge ($\varnothing 3$) décalé par rapport au premier signal horloge, chaque porte NON-ET recevant sur une entrée la sortie de la porte NON-ET précédente et sur son autre entrée le signal de remise à niveau ($\overline{RESET}$), les sorties des portes NON-ET de rang impair (E1, E3, E5, E7) étant envoyées chacune sur un inverseur (I1 à I4), les sorties des portes NON-ET de rang pair (E2, E4, E6) et les sorties des inverseurs (I1 à I4) réalisant les N-1 sorties du registre.

5. Mémoire non-volatile programmable électriquement selon l'une quelconque des revendications 2 et 3, caractérisée en ce que le registre à décalage est constitué par N-1 bascules de type maître-esclave (B1 à B7) connectées en série, les bascules de rang impair (B1, B3,B5, B7) étant comandées par un premier signal-horloge ($\varnothing 3$) et les bascules de rang pair (B2, B4, B6) par un deuxième signal-horloge ($\varnothing 1$) décalé par rapport au premier signal-horloge, les sorties Q des bascules de rang pair et les sorties $\overline{Q}$ des bascules de rang impair réalisant les N-1 sorties du registre.

6. Mémoire non-volatile programmable électriquement selon l'une quelconque des revendications 1 à 5, caractérisée en ce que les deuxièmes moyens pour court-circuiter les premiers moyens lors du passage en mode programmation sont constitués par un circuit en logique combinatoire (21) activé par le signal de commande lecture-écriture $\overline{P2S}$ et par le signal de commande de programmation (PGM) généré en fin de lecture, le circuit en logique combinatoire étant connecté entre le registre à décalage et les circuits d'écriture.

7. Mémoire non volatile programmable électriquement selon la revendication 5, caractérisée en ce que le signal de commande de programmation (PGM) est généré à partir du signal de commande de lecture-écriture ($\overline{P2S}$) par l'inter-

médiaire d'un circuit séparateur de signaux (R2) activé par le signal de commande du N$^{ième}$ circuit d'écriture.

## Claims

1. An electrically programmable non-volatile memory comprising a matrix of memory cells (1) able to be accessed by lines and columns, write circuits (E) and read circuits (L) for applying to said lines and columns potentials representing of a data item to be programmed or representing a read command, and means (6 and 7) organizing the interconnection of the write and read circuits with the memory cells, in which N (N being a number in excess of 1) memory cells are simultaneously programmable, each memory cell effecting a current call when programmed with "1", characterized in that it comprises first means (20) in order to deactivate one by one the write circuits corresponding to N memory cells at the time of the change over from a programming mode to a read mode and second means (21 and R2) in order to short circuit the first means at the time of the change over to the programming mode.

2. The electrically programmable non-volatile memory as claimed in claim 1, characterized in that the first means are constituted by a shift register having an input receiving the read-write command $\overline{(P2S)}$ and having N-1 outputs, the input and the N-1 outputs being respectively connected with N write circuits (E), the shift register being controlled by clock signals ($\phi1$ and $\phi3$) consecutively switching the outputs.

3. The electrically programmable non-volatile memory as claimed in claim 2, characterized in that the shift register receives a level restore signal $(\overline{RESET}$ and RESET) at the time of application of the voltage.

4. The electrically programmable non-volatile memory as claimed in any one of the preceding claims 2 and 3, characterized in that the shift register is constituted by N-1 NOT-AND gates connected in series by the intermediary of MOS transistors (T1 through T7) forming switches, the even numbered MOS transistors (T2, T4 and T6) being controlled by a first clock signal ($\phi1$) and the odd numbered MOS transistors (T1, T3, T5 and T7) being controlled by a second clock signal ($\phi3$) offset in relation to the first clock signal, each NOT-AND gate receiving at one input the output of the preceding NOT-AND gate and at another input the level restore signal $\overline{(RESET)}$, the outputs of the odd NOT-AND gates (E1, E3, E5 and E7) being each fed to an inverter (I1 to I4), the outputs of the even NOT-AND gates (E2, E4 and E6) and the outputs of the inverters (I1 through I4) constituting the N-1 outputs of the register.

5. The electrically programmable non-volatile memory as claimed in any one of the preceding claims 1 and 3, characterized in that the shift register is constituted by N-1 flip-flops of the master-slave type (B1 through B7), connected in series, the odd flip-flops of the (B1, B3, B5 and B7) being controlled by a first clock signal ($\phi3$) and the even flip-flops (B2, B4 and B6) being controlled by a second clock signal ($\phi1$) which is offset in relation to the first clock signal, the outputs Q of the even flip-flops and the outputs $\overline{Q}$ of the odd flip-flops constituting the N-1 outputs of the register.

6. The electrically programmable non-volatile memory as claimed in any one of the preceding claims 1 through 5, characterized in that the second means for short circuiting the first means at the time of the change over to the programming mode are constituted by a combinationary logic circuit (21) activated by the read-write control signal $\overline{(P25)}$ and by the programming control signal (PGM) generated at the end of reading, the combinatory logic circuit being connected between the shift register and the write circuits.

7. The electrically programmable non-volatile memory as claimed in claim 5, characterized in that the programming control signal (PGM) is generated originating from the read-write control signal $\overline{(P2S)}$ by the intermediary of a signal separating circuit (R2) activated by the control signal of the Nth write circuit.

## Ansprüche

1. Elektrisch Programmierbarer Festwertspeicher, mit einer Matrix von Speicherzellen (1), die über Reihen und Spalten zugreifbar sind, Schreibschaltungen (E) und Leseschaltungen (L), die an die Reihen und Spalten die zu programmierenden Daten oder einen Lesebefehl darstellende Potentiale anlegen, und Mitteln (6, 7), die die Verbindung der Schreib- und Leseschaltungen mit den Speicherzellen steuern, in dem N Speicherzellen, mit N größer als 1, gleichzeitig programmierbar sind, wobei jede Speicherzelle während ihrer Programmierung mit "1" einen Stromstoß ausführt, dadurch gekennzeichnet, daß er erste Mittel (20), die während eines Übergangs von einem Programmierbetrieb in einen Lesebetrieb nacheinander die den N Speicherzellen entsprechenden Schreibschaltungen deaktivieren, und zweite Mittel (21, R2), die während eines Übergangs in den Programmierbetrieb die ersten Mittel kurzschließen, umfaßt.

2. Elektrisch programmierbarer Festwertspeicher gemäß Anspruch 1, dadurch gekennzeichnet, daß die ersten Mittel durch ein Schieberegister mit einem das Lese/Schreib-Befehlssignal (P2S) empfangenden Eingang und N-1 Ausgängen gebildet werden, wobei der Eingang und die N-1 Ausgänge entsprechend mit den N Schreibschaltungen (E) verbunden sind, wobei das Schieberegister mit Taktsignalen ($\phi$1, $\phi$3) gesteuert wird, die die Ausgänge nacheinander schalten.

3. Elektrisch programmierbarer Festwertspeicher gemäß Anspruch 2, dadurch gekennzeichnet, daß das Schieberegister bei Anlegen einer Spannung ein Rücksetzsignal auf (RESET, RESET)-Pegel empfängt.

4. Elektrisch programmierbarer Festwertspeicher gemäß einem der Ansprüche 2 und 3, dadurch gekennzeichnet, daß das Schieberegister von N-1 NICHT-UND-Gattern gebildet wird, die über dazwischengeschaltete, Unterbrecher bildende MOS-Transistoren (T1 bis T7) in Reihe geschaltet sind, wobei die geradzahligen MOS-Transistoren (T2, T4, T6) durch ein erstes Taktsignal ($\phi$1) und die ungeradzahligen MOS-Transistoren (T1, T3, T5, T7) durch ein zweites Taktsignal ($\phi$3), das gegenüber dem ersten Taktsignal verschoben ist, gesteuert werden, wobei jedes NICHT-UND-Gatter an einem Eingang die Ausgabe des vorangehenden NICHT-UND-Gatters und an seinem anderen Eingang das Rücksetzsignal auf (RESET)-Pegel empfängt, wobei die Ausgaben der ungeradzahligen NICHT-UND-Gatter (E1, E3, E5, E7) jeweils an einen Inverter (I1 bis I4) geschickt werden, wobei die Ausgänge der geradzahligen NICHT-UND-Gatter (E2, E4, E6) und die Ausgänge der Inverter (I1 bis I4) die N-1 Ausgänge des Registers bilden.

5. Elektrisch programmierbarer Festwertspeicher gemäß einem der Ansprüche 2 und 3, dadurch gekennzeichnet, daß das Schieberegister von N-1 in Reihe geschalteten Kippschaltungen vom Master-Slave-Typ (B1 bis B7) gebildet wird, wobei die ungeradzahligen Kippschaltungen (B1, B3, B5, B7) durch ein erstes Taktsignal ($\phi$) und die geradzahligen Kippschaltungen (B2, B4, B6) durch ein zweites Taktsignal ($\phi$1), das gegenüber dem ersten Taktsignal verschoben ist, gesteuert werden, wobei die Ausgänge Q der geradzahligen Kippschaltungen und die Ausgänge Q̄ der ungeradzahligen Kippschaltungen die N-1 Ausgänge des Registers bilden.

6. Elektrisch programmierbarer Festwertspeicher gemäß einem der Ansprüche 1 bis 5, dadurch gekennzeichnet, daß die zweiten Mittel zum Kurzschließen der ersten Mittel während des Übergangs in einen Programmierbetrieb durch eine logische Kombinatorikschaltung (21) gebildet werden, die durch das Lese/Schreib-Steuersignal (P2S) und durch das Programmier-Steuersignal (PGM), das am Ende des Lesens erzeugt wird, aktiviert wird und die zwischen das Schieberegister und die Schreibschaltungen geschaltet ist.

7. Elektrisch programmierbarer Festwertspeicher gemäß Anspruch 5, dadurch gekennzeichnet, daß das Programmier-Steuersignal (PGM) aus dem Lese/Schreib-Steuersignal (P2S) über eine dazwischengeschaltete Signal-Trennschaltung (R2), die durch das Steuersignal der N-ten Schreibschaltung aktiviert wird, erzeugt wird.

# FIG_1

# FIG_3

FIG_2

CIRCUIT GENERANT LE SIGNAL DE PROGRAMMATION

PLAN MEMOIRE

# FIG_4

FIG_5